# EUROPÄISCHE PATENTSCHRIFT

(11) **EP 2 363 956 B1**
(45) Veröffentlichungstag und Bekanntmachung des Hinweises auf die Patenterteilung: **26.09.2012**
(21) Anmeldenummer: 10155169.5
(22) Anmeldetag: 02.03.2010
(51) Int. Cl.: H03K 17/96

(54) **Kapazitiver Schalter**
Capacitive switch
Commutateur capacitif

(43) Veröffentlichungstag der Anmeldung: 07.09.2011
(73) Patentinhaber: RAFI GmbH & Co. KG, 88276 Berg (DE)
(72) Erfinder: Bulach, Eric, 88074, Meckenbeuren (DE)
(74) Vertreter: Engelhardt & Engelhardt

(56) Entgegenhaltungen:
- EP-A1- 0 054 306
- DE-A1- 19 703 404
- DE-A1-102004 026 836
- US-A1- 2004 189 100

## Beschreibung

Die Erfindung bezieht sich auf einen kapazitiven Schalter nach dem Oberbegriff des Patentanspruches 1.

Solche kapazitiven Schalter werden in einer Vielzahl von Anwendungen eingesetzt. Das von der Sensorfläche erzeugte Kapazitätsfeld wird dabei in Richtung einer Bedienoberfläche abgestrahlt. Sobald das Kapazitätsfeld, beispielsweise durch das Eindringen eines menschlichen Fingers, gestört ist, verändert sich dessen Wert. Durch einen zu der Sensorfläche benachbart angeordneten integrierten Schaltkreis werden diese Veränderungen des Kapazitätsfeldes permanent gemessen, so dass durch einen elektrisch mit dem integrierten Schaltkreis gekoppelten Mikrocontroller ein elektrisches Schaltsignal erzeugbar ist, wenn das Kapazitätsfeld der Sensorfläche einen voreingestellten Grenzwert unter- oder überschreitet.

Aus DE 10 2004 026 836 A1 ist eine Berührungsschalteinrichtung der vorgenannten Art zu entnehmen. Die jeweilige Sensorfläche bildet dabei ein Kapazitätsfeld aus, das durch eine beabstandet zu diesen verlaufenden Abdeckplatte nach außen abstrahlt. Die Auswertung, ob eine Kapazitätsfeldveränderung oberhalb der jeweiligen Sensorfläche stattgefunden hat, erfolgt mit Hilfe einer Auswerteeinrichtung bzw. Mikrocontroller. Jedoch liefert jede Sensorfläche an den Mikrocontroller ein elektrisches Schaltsignal bei einer Kapazitätsfeldveränderung.

Als nachteilig hat sich für einen derartigen kapazitiven Schalter herausgestellt, dass dieser nicht in elektrische Geräte eingesetzt werden kann, die eine bestimmte Sicherheitsanforderung zu erfüllen haben. Fehlschaltungen können beispielsweise dadurch auftreten, dass der integrierte Schaltkreis nach einer bestimmten Lebensdauer nicht mehr korrekt funktioniert oder dass die Synchronisation der Abfrage des Kapazitätsfeldes der Kupferschicht entweder durch den integrierten Schaltkreis oder den Mikrocontroller, der den integrierten Schaltkreis steuert und dessen Signale erfasst, gestört ist. Andere Fehlschaltungen entstehen, wenn das Kapazitätsfeld unbeabsichtigt, beispielsweise im Randbereich, gestört ist, eine Beeinflussung des Kapazitätsfeldes also nicht gewollt gewesen ist.

Wenn dann eine Fehlschaltung des kapazitiven Schalters auftritt und dieser beispielsweise als Bewegungsgeber an einer Werkzeugmaschine eingesetzt ist, funktioniert die Steuerung der Werkzeugmaschine nicht oder erfolgt völlig unbeabsichtigt. Dies führt anschließend zu möglichen schwerwiegenden Unfällen oder sonstigen Betriebsstörungen; möglicherweise wird dadurch die Werkzeugmaschine in ihrer Funktion erheblich beeinträchtigt.

Es besteht daher seit mehreren Jahren ein erheblicher Bedarf, dass die bekannten kapazitiven Schalter auch in anderen elektrischen Geräten verwendet werden können, deren Schalt- und Steuerfunktion zuverlässig und dauerhaft erfolgen soll, da diese kapazitiven Schalter ein bestimmtes Maß an Schaltsicherheit aufweisen müssen.

Es ist daher Aufgabe der Erfindung, einen kapazitiven Schalter der eingangs genannten Gattung zur Verfügung zu stellen, durch den gewährleistet ist, dass elektrische Geräte betrieben werden können, um ein bestimmtes Sicherheitsanforderungsprofil zu erfüllen, dass also die Veränderungen des Kapazitätsfeldes durch den Schalter redundant erfasst sind.

Diese Aufgabe wird erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass in die Leiterplatte mindestens zwei Sensorflächen eingebaut sind, die mit jeweils einem integrierten Schaltkreis und dem Mikrocontroller als Steuer- und Auswerteeinheit elektrisch abgefragt und geregelt sind und die wechselweise die Messung des Kapazitätsfeldes der Kupferschicht vornehmen, ist gewährleistet, dass eine ausreichende Sicherheit für den Betrieb des kapazitiven Schalters vorliegt, denn durch die Anzahl der Sensorflächen können Fehlfunktionen erkannt bzw. ausgeschlossen werden. Wenn nämlich einer der beiden integrierten Schaltkreise an der jeweiligen Sensorfläche nicht korrekt funktioniert, wird durch den Mikrocontroller als Auswerte- und Steuereinheit kein elektrisches Signal erzeugt, da der zweite integrierte Schaltkreis mit seiner Sensorfläche die Abfragewerte des ersten integrierten Schaltkreises nicht bestätigt. Erst wenn die elektrischen Informationen der beiden integrierten Schaltkreise und deren Sensorflächen übereinstimmen, wird durch den Mikrocontroller ein entsprechendes elektrisches Schaltsignal generiert.

Es ist besonders vorteilhaft, wenn zwei Paare von Sensorflächen in die Leiterplatte eingebaut sind und wenn die jeweils ein Paar bildenden Sensorflächen zueinander räumlich versetzt sind und parallel zu einem der Sensorflächen des zweiten Paares angeordnet sind, da durch diese Anordnung die Abfrageredundanz erheblich erhöht ist

Die Leiterplatte ist aus einem elektrisch isolierend wirkenden Material hergestellt, so dass zwischen der Kupferschicht und der Sensorflächen und zwischen den Sensorflächen keine galvanische Verbindung besteht, sondern diese vielmehr elektrisch voneinander getrennt sind.

In der Zeichnung sind zwei erfindungsgemäße Ausführungsbeispiele eines kapazitiven Schalters dargestellt, die nachfolgend näher erläutert sind. Im Einzelnen zeigt:
- Figur 1: ein erstes Ausführungsbeispiel eines kapazitiven Schalters, mit einer Leiterplatte, in der zwei Sensorflächen vorgesehen sind, die das von einer Kupferschicht erzeugte Kapazitätsfeld wechselweise überprüfen, wobei die Sensorflächen jeweils über einen integrierten Schaltkreis elektrisch mit einem Mikrocontroller gekoppelt sind, im Schnitt,
- Figur 2: ein zweites Ausführungsbeispiel eines kapazitiven Schalters, mit einer Leiterplatte, in der vier Sensorflächen eingebaut sind, die das von einer Kupferschicht erzeugte Kapazitätsfeld paarweise und wechselweise überprüfen, wobei die Sensorflächen paarweise über einen integrierten Schaltkreis elektrisch mit einem Mikrocontroller gekoppelt sind, im Schnitt,
- Figur 3: den kapazitiven Schalter gemäß Figur 1 in Draufsicht, wobei die Kupferschicht etwa die von den beiden Sensorflächen erzeugten Messflächen umfasst,
- Figur 4: den kapazitiven Schalter gemäß Figur 2, wobei das von der Kupferschicht abgestrahlte Kapazitätsfeld größer bemessen ist als die von den Sensorflächen gebildete Messflächen, in Draufsicht und
- Figur 5: ein Schaltdiagramm zur Steuerung der integrierten Schaltkreise gemäß Figur 1 oder 2.

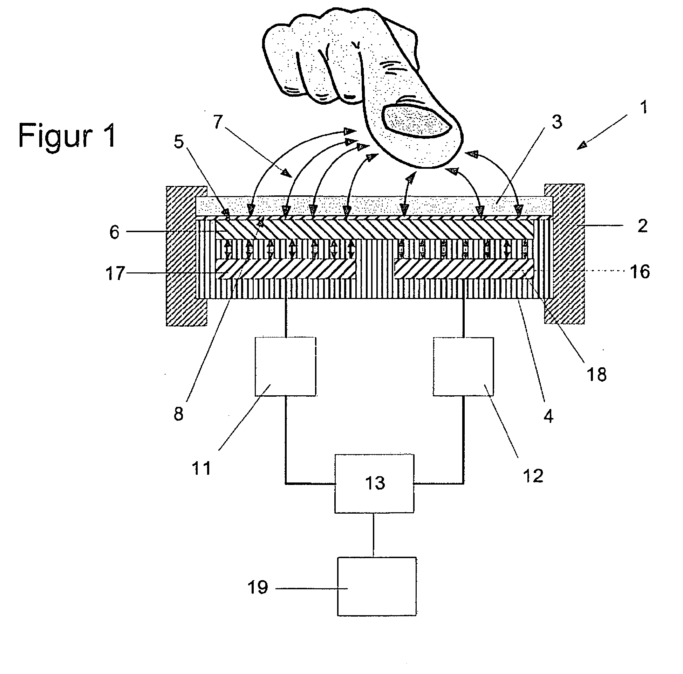

In Figur 1 ist ein kapazitiver Schalter 1 abgebildet, der zur Steuerung eines elektrischen Gerätes, beispielsweise als Steuereinrichtung für eine Werkzeugmaschine, eingesetzt werden soll. Um die Schalt- und Steuerfunktion des kapazitiven Schalters 1 möglichst redundant zu überprüfen, so dass dessen Funktion einem vorgegebenen gesetzlichen Sicherheitsstandart entspricht, besteht der kapazitive Schalter 1 aus zwei in einer Leiterplatte 4 eingebauten Sensorflächen 17 und 18, durch die ein auf der Oberfläche 5 der Leiterplatte 4 aufgebrachte Kupferschicht 6 erzeugendes Kapazitätsfeld 7, wie nachfolgend näher erläutert, erfasst ist.

Die Leiterplatte 4 und die Kupferschicht 6 sind in einem Gehäuserahmen 2 eingebaut. Die Kupferschicht 6 ist nach außen durch eine dünnwandige, transparente oder semitransparente Abdeckplatte 3 verschlossen, so dass die unterhalb der Abdeckplatte 3 angeordneten elektrischen Sensorflächen 17, 18 luftdicht nach außen gekapselt sind. Die Sensorflächen 17 und 18 sind elektrisch an zwei integrierten Schaltkreise 11 und 12 angeschlossen. Die integrierten Schaltkreise 11 und 12 sind in bekannter Weise als Halbleiter ausgebildet.

Die Sensorflächen 17, 18 verlaufen in einer gemeinsamen Ebene 16, die parallel zu der Kupferschicht 6 und beabstandet zu dieser angeordnet ist.

Die Leiterplatte 4 ummantelt die jeweilige Sensorfläche 17 oder 18 vollständig; diese ist zudem aus einem isolierenden Material hergestellt, so dass die Kupfterschicht 6 und die Sensorflächen 17, 18 voneinander galvanisch getrennt sind.

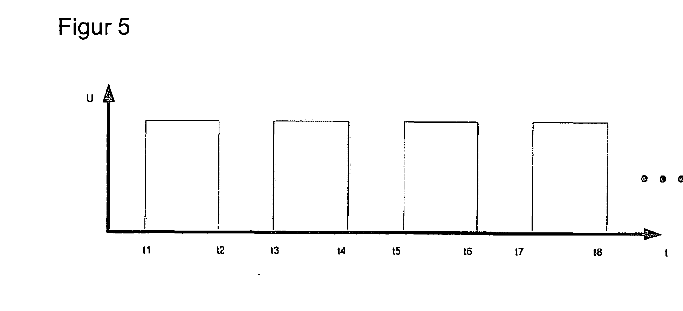

Aus der Figur 5 kann der Überwachungszyklus des jeweiligen Schaltkreises 11 oder 12 entnommen werden, denn durch den Mikrokontroller 13 werden die beiden integrierten Schaltkreise 11 und 12 wechselweise angesteuert, so dass gemäß der abgebildeten Steuerfunktion einer der beiden Sensorflächen 17 oder 18 das von der Kupferschicht 6 erzeugte und nach außen in Richtung der Abdeckplatte 3 verlaufende Kapazitätsfeld 7 erfasst.

Wird nun beispielsweise ein menschlicher Finger in das Kapazitätsfeld 7 eingeführt, verändert sich dessen Wert. Unabhängig davon, welcher der beiden integrierten Schaltkreise 11 oder 12 gerade durch den Mikrokontroller 13 zur Erfassung des Kapazitätsfeldes 7 freigeschaltet ist, wird der jeweilige Sensorfläche 17 oder 18 die Veränderung des Kapazitätsfeldes 7 ermitteln und diese Kapazitätsfeldveränderung 7 an den Mikrokontroller 13 über den jeweiligen integrierten Schaltkreis 11 oder 12 weiterleiten. Sobald die andere der beiden Sensorflächen 17 oder 18 von dem Mikrokontroller 13 freigeschaltet ist, erfasst diese die Kapazitätsfeldveränderung 7 in gleicher Weise, so dass das erste Schaltsignal des jeweiligen integrierten Schaltkreises 11 oder 12 durch den zweiten integrierten Schaltkreis 11 oder 12 bestätigt ist. Durch diesen Abfragezyklus wird demnach die erste Abfrage überprüft, so dass die Schaltfehlfunktionen reduziert sind, denn erst wenn durch beide Sensorflächen 17 und 18 eine Kapazitätsfeldveränderung 7 festgestellt und diese an den Mikrokontroller 13 weitergeleitet ist, wird von diesem ein elektrisches Schaltsignal generiert, das über eine Schnittstelle 19 an die Werkzeugmaschine geleitet ist.

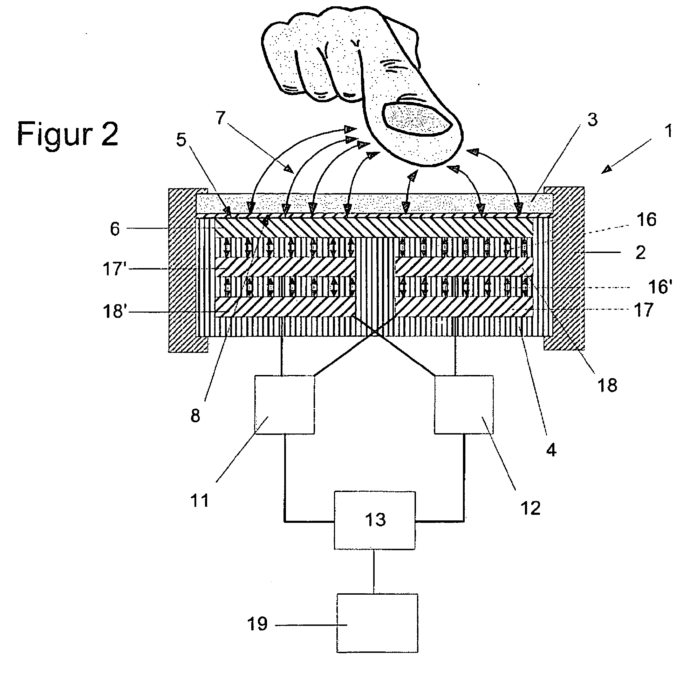

In Figur 2 sind vier Sensorflächen 17, 18, 17', 18' vorgesehen. Zwei der vier Sensorflächen 17, 17', 18, 18' sind paarweise zu einer gemeinsamen Abfrageeinheit zusammengeschaltet. Dabei verlaufen die Sensorflächen 17 und 18 bzw. 17' und 18' jeweils in einer gemeinsamen Ebene, die parallel und unterschiedlich beabstandet zu der Kupferschicht 6 ausgerichtet ist. Bezogen auf die Kupferschicht 6 sind die Sensorflächen 17 und 18 zwischen dieser und den Sensorflächen 17' und 18' angeordnet.

Darüber hinaus sind die beiden Paare von Sensorflächen 17 und 17' bzw. 18 und 18' räumlich seitlich versetzt zueinander, jedoch fluchtend übereinander liegend zu der jeweiligen anderen Sensorfläche 17, 17', 18, 18' des anderen Paares in die Leiterplatte 4 eingebaut. Durch diese konstruktive Anordnung der Sensorflächen 17, 17', 18, 18' ist erreicht, dass die Abfragesicherheit weiter erhöht ist, denn nunmehr wird die Veränderung des Kapazitätsfeldes 7 durch zwei Paare von Sensorflächen 17, 17' bzw. 18, 18' erfasst, so dass die Redundanz des kapazitiven Schalters 1 erhöht ist.

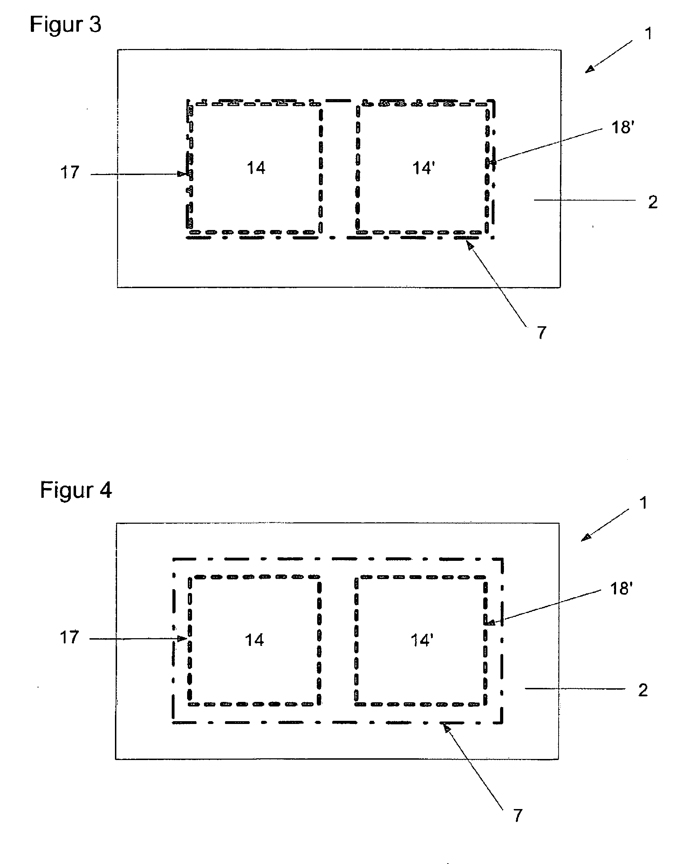

Aus Figur 3 ist zu entnehmen, dass die von den Sensorflächen 17, 18 gebildete Messfläche 14 bzw. 15 gleich groß ist und dass das von der Kupferschicht 6 erzeugte Kapazitätsfeld 7 in etwa dem von den Messflächen 14 und 15 gebildeten Umfang entspricht.

In Figur 4 ist gezeigt, dass die Messflächen 14 und 15 eine kleinere Fläche umfassen, als die die von dem Kapazitätsfeld 7 erzeugt ist.

Die Sensorflächen 17 und 18 bzw. 17' und 18' in Figur 2 sind zueinander beabstandet, so dass zwischen diesen ein Freiraum gebildet ist. Selbst wenn das Kapazitätsfeld 7 in diesem Freiraum durch Eindringen eines menschlichen Fingers gestört ist, behindert dies die Schaltsicherheit des kapazitiven Schalters 1 nicht, denn die beiden Sensorflächen 17 und 18 bzw. die zwei Paare von Sensorflächen 17 und 18 bzw. 17' und 18' werden wechselweise durch den Mikrokontroller 13 und die integrierten Schaltkreise 11, 12 abgefragt.

In den Figuren 3 und 4 sind die Messflächen 14 bzw. 15 rechteckförmig ausgestaltet. In Abhängigkeit von der Querschnittsfläche des jeweiligen verwendeten Sensorfläche 17, 17' und 18, 18' kann die Außenkontur der Messfläche 14 bzw. 14' variieren. Es ist denkbar beispielsweise die erste Sensorfläche T-förmig und die zweite Sensorfläche 18 U-förmig auszugestalten, so dass die erste Sensorfläche 17 teilweise von der zweiten Sensorfläche 18 umgriffen ist. Die Außenkontur der jeweiligen Messfläche 14 bzw. 15 kann auch rund, eliptisch oder mehreckig ausgebildet sein ― dies hängt von den an dem kapazitiven Schalter 1 vorzusehenden Anwendungsprofilen ab.

## Patentansprüche

1. Kapazitiver Schalter (1), bestehend aus einem Gehäuserahmen (2), durch den eine dünnwandige Abdeckplatte (3) gehalten ist, aus einer Leiterplatte (4), in die mindestens zwei Sensorflächen (17, 17', 18, 18') eingebaut sind, die über jeweils einen integrierten Schaltkreis (11, 12) mit einem Mikrocontroller (13) als Steuer- und Auswerteeinheit elektrisch gekoppelt sind,
**dadurch gekennzeichnet,**
**dass** auf der der Abdeckplatte (3) zugewandten Oberfläche (5) der Leiterplatte (4) eine ein Kapazitätsfeld (7) erzeugende Kupferschicht (6) aufgebracht ist, die mit der Innenfläche (8) der Abdeckplatte (3) fest verbunden ist, dass die Leiterplatte (4) als Isolierung zwischen der Kupferschicht (6) und den Sensorflächen (17, 17', 18, 18') wirkt, und dass beide integrierte Schaltkreise (11, 12, 11', 12') durch den Mikrocontroller (13) wechselweise zur Messung des Kapazitätsfeldes (7) der Kupferschicht (6) derart angesteuert sind, dass die jeweils andere Sensorfläche (17 oder 18) durch den Mikrocontroller (13) freigeschaltet ist.

2. Schalter nach Anspruch 1,
**dadurch gekennzeichnet,**
**dass** die Sensorflächen (17, 18 bzw. 17', 18') der integrierten Schaltkreise (11, 12) paarweise in einer parallel zu der Kupferschicht (6) verlaufenden Ebene angeordnet sind.

3. Schalter nach Anspruch 1 oder 2,
**dadurch gekennzeichnet,**
**dass** die Sensorflächen (17, 17', 18, 18') zueinander beabstandet sind und dass von diesem eine Messfläche (14, 14') erzeugt ist, die dem Umfang der Sensorfläche (17, 18) entspricht.

4. Schalter nach einem der vorgenannten Ansprüche,
dass jeweils zwei Paare Sensorflächen (17, 17' und 18, 18') in der Leiterplatte (4) vorgesehen sind, dass zwei der Sensorflächen (17, 17') ein erstes Paar bilden, die seitlich zueinander versetzt und jeweils fluchtend übereinander liegend zu einem zweiten Paar von Sensorflächen (18, 18') angeordnet sind.

5. Schalter nach Anspruch 1,
**dadurch gekennzeichnet,**
**dass** die von den Sensorflächen (17, 17', 18, 18') jeweils gebildeten Messflächen (14) gleich groß bemessen ist.

6. Schalter nach Anspruch 1,
**dadurch gekennzeichnet,**
**dass** die von den Sensorflächen (17, 17', 18, 18') gebildeten Messflächen (14, 14') als unterschiedliche geometrische Figuren ausgebildet sind und dass zwischen zwei benachbarten Messflächen (14, 14') ein vorgegebener Abstand vorgesehen ist.

7. Schalter nach Anspruch 6,
**dadurch gekennzeichnet,**
**dass** die Messfläche (14) der ersten Sensorfläche (17) als viereckiger Rahmen und die Messfläche (14) der zweiten Sensorfläche als Rechteck ausgebildet sind und dass durch die erste Messfläche (14) die zweite Messfläche (14') umschlossen ist.

8. Schalter nach Anspruch 6,
**dadurch gekennzeichnet,**
**dass** die von der ersten Sensorfläche (17) gebildete Messfläche (14) T-förmig und die von der zweiten Sensorfläche (18) gebildete Messfläche (14') U-förmig ausgebildet sind und dass die Messfläche (14) der ersten Sensorfläche (17) bereichsweise von der Messfläche (14') der zweiten Sensorfläche (18) umschlossen und von diesem beabstandet ist.

9. Schalter nach Anspruch 1,
**dadurch gekennzeichnet,**
**dass** die beiden Sensorflächen (17, 18) auf unterschiedlichen Höhenniveaus in der Leiterplatte angeordnet sind.

## Claims

1. A capacitive switch (1), consisting of a housing frame (2) by means of which a thin-walled cover plate (3) is held, of a printed circuit board (4) in which at least two sensor surfaces (17, 17', 18, 18') are installed, each of which is electrically connected via an integrated circuit (11, 12) to a microcontroller (13) as a control and evaluation unit,
**characterised in that**,
the surface (5) of the printed circuit board (4) facing towards the cover plate (3) has a copper layer (6) applied to it, which creates a capacitive field (7) and is firmly connected to the inside surface (8) of the cover plate (3), that the printed circuit board (4) acts as insulation between the copper layer (6) and the sensor surfaces (17, 17', 18, 18'), and that both integrated circuits (11, 12, 11', 12') are controlled alternately by the microcontroller (13) for measuring the capacitive field (7) of the copper layer (6) in such a way that the other sensor surface (17 or 18) is isolated by the microcontroller (13) in each case.

2. The switch in accordance with Claim 1,
**characterised in that**,
the sensor surfaces (17, 18 or 17', 18') of the integrated circuits (11, 12) are arranged in pairs in a plane running in parallel to the copper layer (6).

3. The switch in accordance with Claim 1 or 2,
**characterised in that**,
the sensor surfaces (17, 17', 18, 18') are spaced apart from one another and that this generates a measuring surface (14, 14') which corresponds to the extent of the sensor surface (17, 18).

4. The switch in accordance with one of the aforementioned claims,
**characterised in that**,
two pairs of sensor surfaces (17, 17' and 18, 18') are provided in the printed circuit board (4), that two of the sensor surfaces (17, 17') form a first pair which are offset laterally from one another and are positioned one above the other in alignment with a second pair of sensor surfaces (18, 18').

5. The switch in accordance with Claim 1,
**characterised in that**,
each of the measuring surfaces (14) formed by the sensor surfaces (17, 17', 18, 18') has the same size.

6. The switch in accordance with Claim 1,
**characterised in that**,
the measuring surfaces (14, 14') formed by the sensor surfaces (17; 17', 18, 18') are configured as different geometrical figures and that there is a specified distance between the adjacent measuring surfaces (14, 14').

7. The switch in accordance Claim 6,
**characterised in that**,
the measuring surface (14) of the first sensor surface (17) is configured as a rectangular frame and the measuring surface (14') of the second sensor surface as a rectangle, and that the first measuring surface (14) encloses the second measuring surfaces (14').

8. The switch in accordance with Claim 6,
**characterised in that**,
the measuring surface (14) formed by the first sensor surface (17) is configured with a T-shape and the measuring surface (14') formed by the second sensor surface (18) is configured with a U-shape, and that the measuring surface (14) of the first sensor surface (17) is partially enclosed by the measuring surface (14') of the second sensor surface (18) and is spaced apart from it.

9. The switch in accordance with Claim 1,
**characterised in that**,
the two sensor surfaces (17, 18) are arranged on different height levels in the printed circuit board.

## Revendications

1. Commutateur capacitif (1) comprenant un cadre (2) retenant un fine plaque de recouvrement (3) et une platine conductrice (4), dans laquelle il est intégré au moins deux aires à effleurement (17, 17', 18, 18'), qui, par l'intermédiaire d'un circuit imprimé respectif (11, 12), sont couplées électriquement à un microcontrôleur (13) en tant qu'unité de commande et d'évaluation,
**caractérisé en ce que**
sur la surface (5) de la platine conductrice (4) donnant sur la plaque de recouvrement (3), il est prévu une couche de cuivre (6) produisant un champ capacitif (7) et qui est liée rigidement à la face intérieure (8) de la plaque de recouvrement (3), que la platine conductrice (4) sert d'isolement entre la couche de cuivre (6) et les aires à effleurement (17, 17', 18, 18'), et que le microcontrôleur (13) actionne alternativement les deux circuits imprimés (11, 12, 11', 12') en vue de la mesure du champ capacitif (7) de la couche de cuivre (6) de sorte que l'autre aire à effleurement respective (17 ou 18) est libérée par le microcontrôleur (13).

2. Commutateur d'après la revendication 1,
**caractérisé en ce que**
les aires à effleurement (17, 18 ou 17', 18') des circuits imprimés (11, 12) sont arrangées par paires dans un plan parallèle à la couche de cuivre (6).

3. Commutateur d'après les revendications 1 ou 2,
**caractérisé en ce que**
les aires à effleurement (17, 17', 18, 18') sont espacées entr'elles et qu'il en est formé une surface de mesure (14, 14') correspondant au pourtour de l'aire à effleurement (17, 18).

4. Commutateur d'après une des revendications précédentes,
**caractérisé en ce que**
dans la platine conductrice (4), il est prévu respectivement deux paires d'aires à effleurement (17, 17' et 18, 18') et que deux des aires à effleurement (17, 17') forment une première paire espacée latéralement l'une par rapport à l'autre et en alignement précis l'une au-dessus de l'autre par rapport à une deuxième paire d'aires à effleurement (18, 18').

5. Commutateur d'après la revendication 1,
**caractérisé en ce que**
les surfaces de mesure (14) formées respectivement par les aires à effleurement (17, 17', 18, 18') ont les mêmes dimensions.

6. Commutateur d'après la revendication 1,
**caractérisé en ce que**
les surfaces de mesure (14, 14') formées par les aires à effleurement (17, 17', 18, 18') ont des géométries différentes et qu'entre deux surfaces de mesure (14, 14') voisines, il est prévu une distance déterminée.

7. Commutateur d'après la revendication 6,
**caractérisé en ce que**
la surface de mesure (14) de la première aire à effleurement (17) est conçue sous la forme d'un cadre rectangulaire et la surface de mesure (14) de la deuxième aire à effleurement sous la forme d'un rectangle, et que la première surface de mesure (14) entoure la deuxième surface de mesure (14').

8. Commutateur d'après la revendication 6,
**caractérisé en ce que**
la surface de mesure (14) formée par la première aire à effleurement (17) est conçue sous la forme d'un T et la surface de mesure (14') formée par la deuxième aire à effleurement (18) sous la forme d'un U, et que la surface de mesure (14) de la première aire à effleurement (17) est entourée, par endroits et avec une distance déterminée, par la surface de mesure (14') de la deuxième aire à effleurement (18).

9. Commutateur d'après la revendication 1,
**caractérisé en ce que**
les deux aires à effleurement (17, 18) sont arrangées à des hauteurs différentes dans la platine conductrice.
